Europäisches Patentamt

European Patent Office

Office européen des brevets

(11) Publication number: **0 065 998**
**B1**

# EUROPEAN PATENT SPECIFICATION

(45) Date of publication of patent specification: **19.03.86**

(21) Application number: **81104138.3**

(22) Date of filing: **29.05.81**

(51) Int. Cl.⁴: **H 03 K 21/02, G 01 P 13/04**

(54) **Pulse detection circuit.**

(43) Date of publication of application:
**08.12.82 Bulletin 82/49**

(45) Publication of the grant of the patent:
**19.03.86 Bulletin 86/12**

(84) Designated Contracting States:
**DE FR GB**

(56) References cited:
**DE-A-2 030 841**
**DE-A-2 744 201**
**DE-B-1 166 827**
**DE-B-1 166 828**
**DE-B-1 200 359**
**DE-B-1 275 127**
**DE-B-2 160 247**
**FR-A-1 236 705**
**US-A-3 482 132**
**US-A-3 575 608**
**US-A-3 967 271**

**ELECTRONICS INTERNATIONAL, Vol. 53, No.
20, 11 September 1980 New York F. AMTHOR
"Multiplier Increases Resolution of Standard
Shaft Encoders" page 139
Patents Abstracts of Japan Vol. 5, No. 99, 26
June 1981 page 771E63**

(73) Proprietor: **Matsushita Electric Industrial Co.,
Ltd.
1006, Oaza Kadoma
Kadoma-shi Osaka-fu, 571 (JP)**

(72) Inventor: **Takemura, Takehide
13-19, Kitanakaburi 1-chome
Hirakata City, 573 (JP)**

(74) Representative: **Kirschner, Klaus Dieter et al
Patentanwälte Kirschner & Grosse Herzog-
Wilhelm-Strasse 17
D-8000 München 2 (DE)**

(56) References cited:
**ELEKTRONIK, Vol. 27, No. 6, June 1978
München P. MÜLLER "Richtungsdiskriminator
mit Vor-/Rückwärtszähler" page 100**

**RADIO FERNSEHEN ELEKTRONIK Vol. 27, No.
9, September 1978, Berlin G. TURINSKY
"Schaltungsbeispiele mit CMOS-Schaltkreisen"
pages 551 to 555
Patents Abstracts of Japan Vol. 1, No. 135, 9
November 1977 page 6277E77**

## Description

Field of the invention

Ths present invention relates to a pulse detection circuit according to the first portion of claim 1.

Description of the prior art

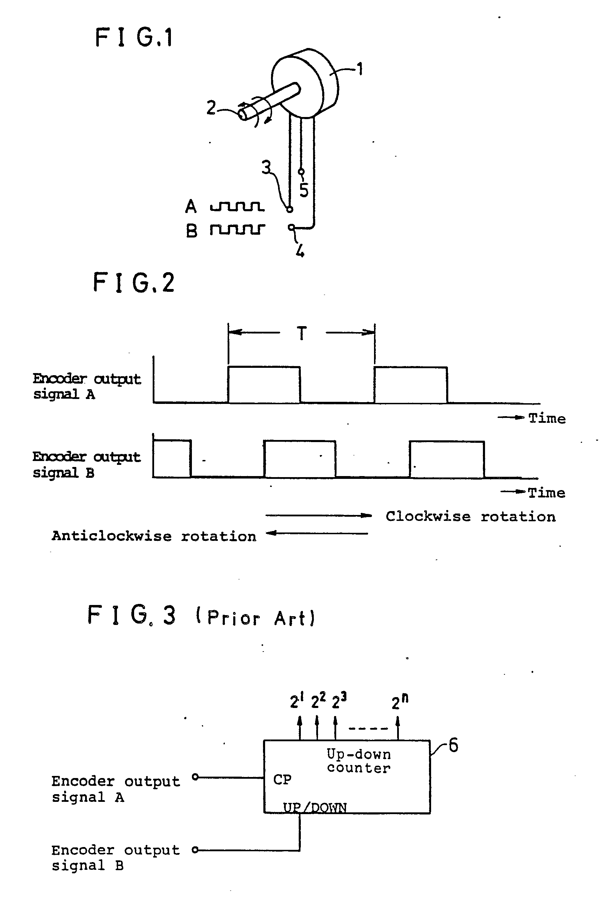

In general, the rotary encoder is embodied to generate output signals A and B of different phase simultaneously in response to the rotation of a shaft 2 being projected from a body 1 thereof as shown by Fig. 1. Numbers of the output pulses of the signals A and B issued from the terminals 3 and 4 of the encoder, respectively, correspond to the rotational angle of the shaft 2, which is then detected by counting the pulses contained in the output signals A and B. In Fig. 1, numeral 5 represents a common terminal. It is needless to say that the larger the number of pulses per rotation of the shaft 2 contained in the output signal of the rotary encoder, the higher the accuracy of the detection of the rotational angle of the shaft 2 will be.

Namely, any physical quantity is converted into a rotational motion of the shaft 2 of the rotary encoder, which can convert a change in the physical quantity into a change in an electric signal, usually a digital data composed of the pulses. And by counting these pulses by a counter composed of an IC, an accurate measurement of the physical quantity can be made in an easy and simple manner.

Incidentally, the output signals A and B, derived from such the rotary encoder, are usually designed to have pulse sequences of phases being shifted with each other as shown in Fig. 2. By detecting this phase shift, the rotary encoder shown in Fig. 1 can discriminate the rotational direction of the shaft 2 based on a relative phase difference, whether it rotates clockwisely or anti-clockwisely. As a pulse detection circuit for detecting the phase shift between the pulses contained in both of the encoder output signal to discriminate the rotational direction, and for generating a control signal, the following circuits have hitherto been known to the art.

One example of such a conventional circuit includes the use of an up-down counter 6 shown in Fig. 3, wherein one of the encoder output signals is fed to the clock input terminal CP and the other is fed to the up-down input terminal UP/DOWN of the up-down counter 6, respectively. According to this arrangement, the up-down counter 6 counts the rise-up edge of the pulse contained in the encoder output signal A, which is fed to the clock input terminal CP. Hence the up-down counter becomes "up" state in response to one level, for instance, a high level (hereinafter, simply referred to as "H" level) of the encoder output signal B, which is fed to the up-down input terminal UP/DOWN, while it becomes its "down" state in response to an opposite level, i.e., a low level ("L" level).

As indicated above, if the encoder output signals A and B are fed to the clock input terminal CP and the up-down input terminal UP/DOWN of the up-down counter 6, respectively, the counter 6 counts downwardly by the clockwise rotation of the encoder shaft and counts upwards by the anticlockwise rotation shown in Fig. 2, discriminatively. The cumulated count value of this up-down counter indicates the rotational direction and angle of the encoder shaft.

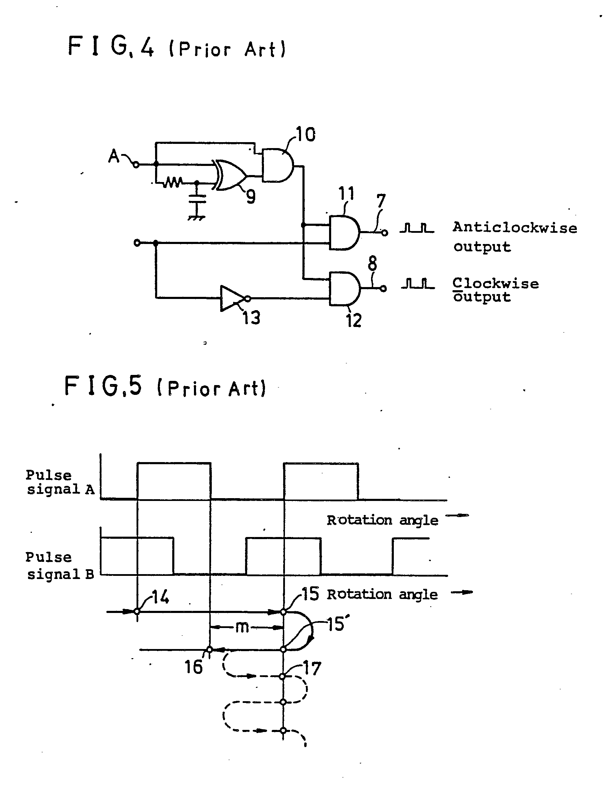

Another example of the conventional measure includes the use of logic circuit composed of an exclusive OR gate 9, three AND gates 10, 11 and 12, and an inverter 13, shown in Fig. 4. In this logic circuit, the rise-up edge of the pulse contained in the encoder output signal A is detected by the exclusive OR gate 9 in combination with the AND gate 10 to generate a pulse signal at the output terminal of the AND gate, which output signal is fed to the one input terminals of the AND gates 11 and 12. This output signal therefore causes either of the AND gates 11 and 12 to issue a pulse signal, on the basis of the level in the encoder output signal B at each time when the rise-up edge of the signal A is detected. Namely, a pulse signal is issued from the AND gate 11, if the encoder output signal B is in its "H" level, whereas the pulse signal is issued from the AND gate 12, if the signal B is in its "L" level. An output terminal 7 of this logic circuit therefore issues an output signal if the encoder shaft rotate anti-clockwisely and another output terminal 8 issues an output signal if the encoder shaft rotate clockwisely.

These output signals are then counted by a conventional counter to give a desired control signal.

Two major disadvantages are, however, inherent to those conventional arrangements, and will be described below.

One of the major disadvantage is a liability of causing an erroneous counting. In general, the encoder as shown in Fig. 1 may be embodied in an optical or mechanical contact system, from which an output signal in an ideal rectangular waveform as depicted in Fig. 2 cannot usually obtained. On the contrary, it cannot avoid an incident of chattering sudden burst of noise (chattering noise) at or adjacent to rise-up or fall-down edge of the pulse contained in its output signal because of the instability or the like in the contacts at the times of its close or opening. If the chattering noise occurs, erroneously many numbers of pulses would be contained in the encoder output signal, which is to be received by, for instance, the clock input terminal CP of the up-down counter shown in Fig. 3 to cause a count value higher than the actual count.

In order to prevent such an erroneous count due to the chattering, a use of a low pass filter (LPF) comprising an integral circuit composed of a capcitor and a resister has hiherto been proposed. The encoder output signal is fed to the detection circuit through the LPF. In a case wherein, the period of the encoder output signal is approximately constant, in the other words, the rotational frequency of the shaft 2 is constant, the above-mentioned means of using a LPF is fairly effective, because the time period during which the chattering occurs (chattering time) is almost constant. However, the length of the chattering time generally depends on the length of the period or pulse duration of the encoder output signal, and hence is usually varying. Therefore, if the LPF is adjusted to effective for an encoder output signal in a state of long period (corresponding to a low rotational frequency of the shaft) by enlarging the time constant of the integral circuit, the response of the detecting circuit will become insufficient when the period is shortened and the circuit itself will be unable to count the pulse properly. Conversely, if the LPF is adjusted to be effective for an encoder output signal in a state of short period (a high rotational frequency), the possibility of the detecting circuit for committing an erroneous counting will be made greater when the period is elongated, because the LPF cannot absorve the chattering.

Another major disadvantage of the conventional technique is in a possibility of commiting an erroneous counting at a time of changing the rotational direction of the encoder shaft. This will be elucidated in detail by referring to Fig. 5, wherein the pulse sequences in the encoder output signals A and B are represented by waveforms with respect to relation angles in the first and second lines respectively, while the third line schematically indicates the example of changings of rotational direction of the encoder. When the shaft of the encoder rotates in the direction indicated by arrows, the circuit counts up at point 14 and 15 which correspond to a rise-up edges of the pulses contained in the encoder output signal A. Next, if the rotational direction of the shaft is changed immediately after passing point 15, the circuit counts down not at point 15' but at point 16 which corresponds to a rise-up edge with respect to the leftward direction of the pulse contained in the encoder output signal A. Therefore as indicated above, an error represented by "m" in Fig. 5 which is a distance from point 15' to point 16 occurs during the while the detecting circuit counts up at the point 15 and counts down at the point 16 after the change in the rotational direction. Furthermore, if the rotational direction is changed again before passing the point 16 as indicated by an arrow along a broken line in Fig. 5, the detecting circuit counts up again at a point 17 and returning rotation is not represented by the output. Therefore, if such motion of broken line arrows are repeated, a cumulative error value of will be greater.

A further example of a conventional pulse detection circuit is disclosed in Electronics International, Vol 53, No. 20, September 1980 page 139. This pulse detection circuit comprises a first and a second input terminal, each for receiving either one of encoder output signals containing pulse trains being shifted in phase with respect to each other, one-shot multivibrator circuits operated by at least one edge of the pulses of the pulse trains to be counted, a first gate circuit composed of eight AND gates to logically combine the output signals of the detector circuits, and a second gate circuit composed of four OR gates for logically combining the output signals of the AND gates.

The one-shot multivibrator circuits also form first and second rise-up detectors for detecting the rise-up edges of the pulses of the pulse trains, and of first and second fall-down detectors for detecting the fall-down edges of the pulses of the pulse trains; the first gate circuit composed of the eight AND gates is for obtaining a logical product of the output signals of either one of the first rise-up and fall-down detectors, and the signal level at the second input terminal, or a logical product of the output of either one of the second rise-up and fall-down detectors at the signal level and the first input terminal; and the second gate circuit composed of the four OR gates is for obtaining a logical sum of the logical products obtained by the light AND gates in the first gate circuit.

As the input signals are supplied also to inverter circuits, these additional circuits are necessary and as the rise-up and fall-down detectors are constituted by one-shot multivibrators capacitance elements are required. Especially, because of the use of these capacitance elements the integration in an integrated circuit is very difficult.

Summary of the invention

It is therefore the primary object of the present invention to provide a pulse detection circuit which obviates the disadvantages inherent to those conventional arrangements.

It is another object of the present invention to provide a pulse detection circuit which will not commit an erroneous counting of pulses contained in the encoder output signals even if chatterings are incidentally contained in the encoder output signals and if the phase relation between the two signals is temporarily reversed, to perform the pulse detection in a very high accuracy.

It is still another object of the present invention to provide a pulse detection circuit of high definition, which counts four different combinations of modes obtained for one period of the encoder output signals.

According to the present invention this object is achieved by the features of the characterizing portion of claim 1.

Brief description of the drawings

Fig. 1 is a schematic view elucidating a performance of a rotary encoder in general use,

Fig. 2 is waveform diagrams of the output signal derived from said encoder,

Fig. 3 is a circuit diagram showing a conventional pulse detection circuit,

Fig. 4 is a circuit diagram showing another conventional pulse detection circuit,

Fig. 5 is a schematic view for illustrating the disadvantages of the circuit shown in Fig. 4,

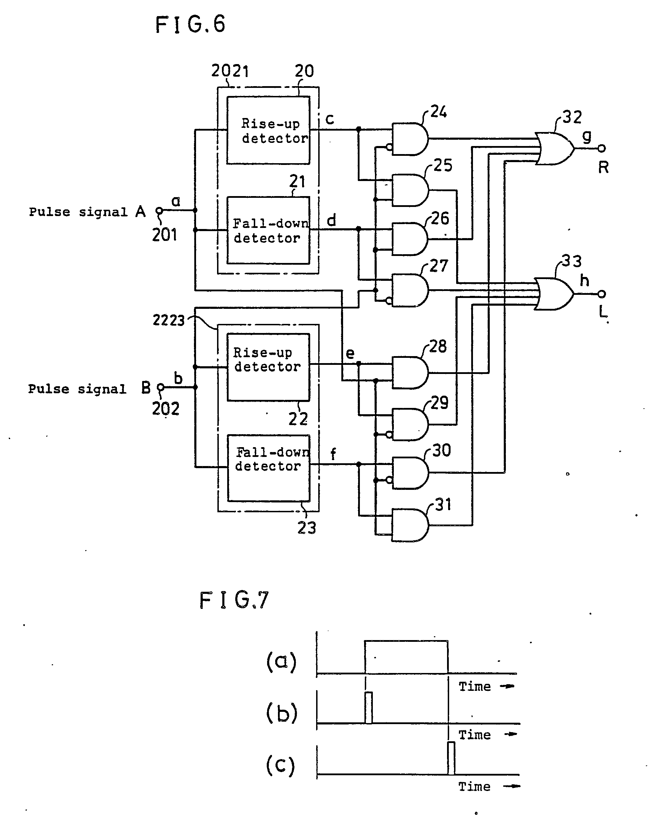

Fig. 6 is a circuit diagram showing a fundamental arrangement of the pulse detection circuit embodying the present invention.

Figs. 7(a), 7(b) and 7(c) are timing charts for elucidating the performance of a rise-up/fall-down detectors in the circuit shown in Fig. 6,

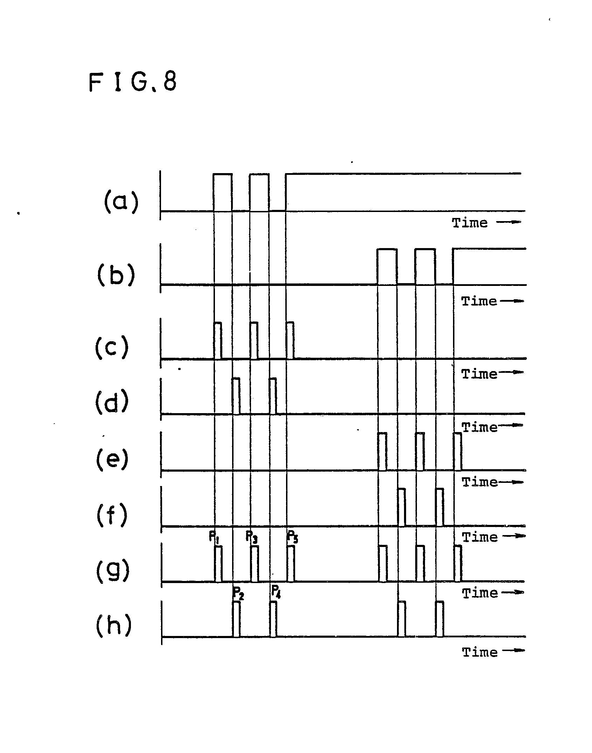

Fig. 8 is a set of timing charts representing signals appeared at various parts of the circuit shown in Fig. 6,

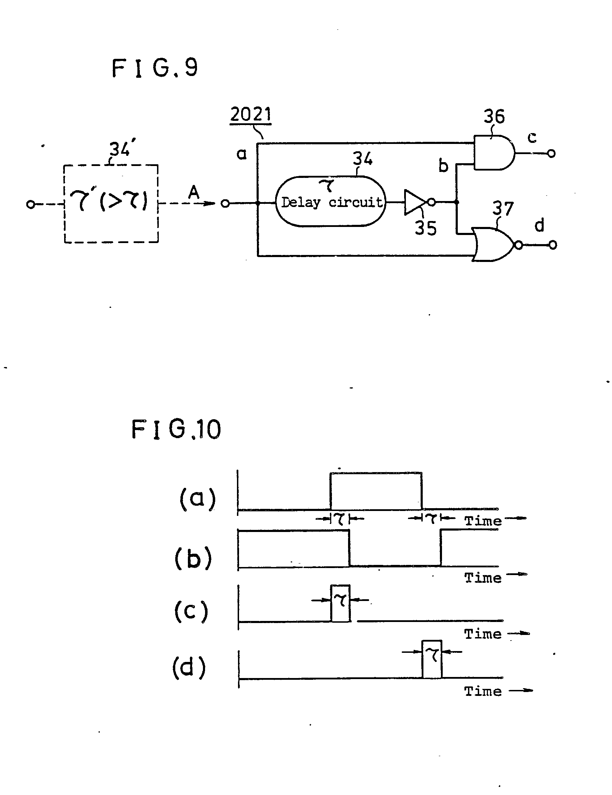

Fig. 9 is a circuit diagram showing a concrete embodiment of the rise-up/fall-down detector in the pulse detection circuit embodying the present invention,

Fig. 10 is a set of timing charts representing signals appeared at various parts of the circuit shown in Fig. 9,

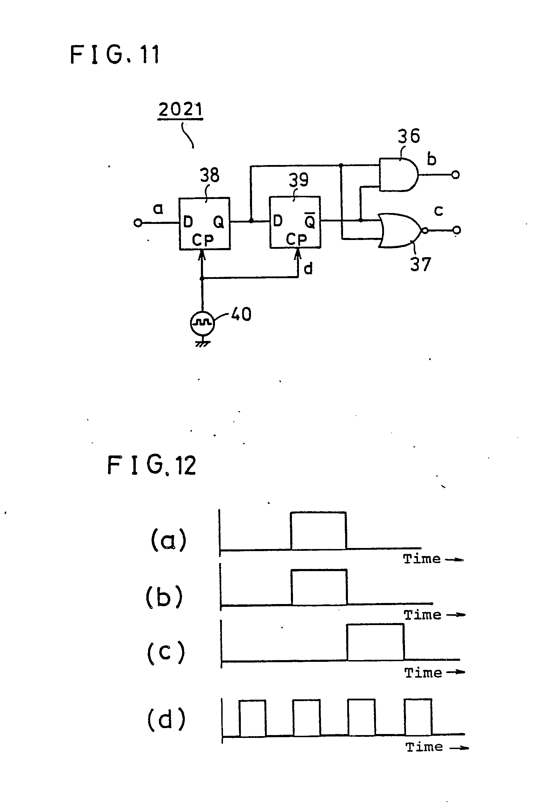

Fig. 11 is a circuit diagram showing another concrete embodiment of the rise-up/fall-down detector in the pulse detection circuit embodying the present invention,

Fig. 12 is a set of timing charts representing signals appeared at various parts of the circuit shown in Fig. 11,

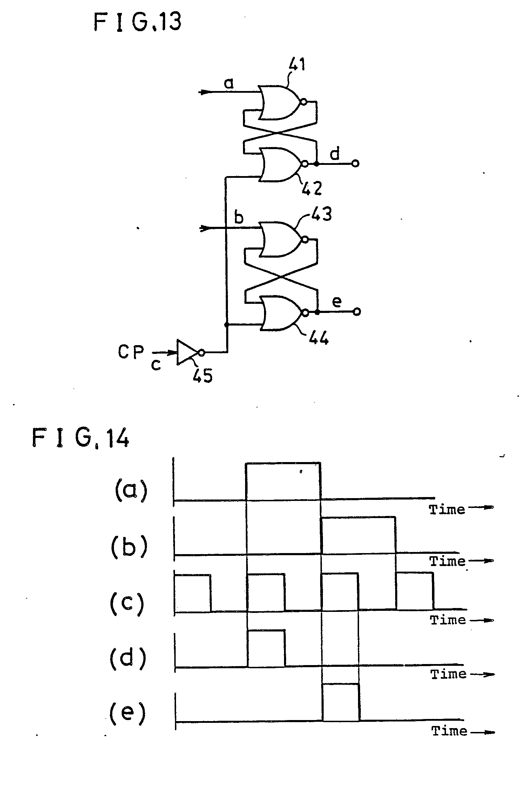

Fig. 13 is a circuit diagram of a partial circuit which may be employed together with the circuit shown in Fig. 11, and

Fig. 14 is a set of timing charts representing signals appeared at various points of the circuit shown in Fig. 13.

Description of the preferred embodiment

In the fundamental arrangement of the pulse detection circuit of the present invention shown in Fig. 6, the rise-up/fall-down edges of the pulses contained in the encoder output signals A and B are positively utilized.

The modes of the encoder output signals A and B are summarized in the following table by classifying them into the rotation of the encoder shaft in clockwise direction and anti-clockwise direction.

| Direction of rotation | Output signal appeared at AND gate of (in Fig. 6) | Encoder output signal | |
|---|---|---|---|
| Clockwise R-1 | 24 | A($\nearrow$) (Rise-up at the signal A) | B(L) ("L" level of the signal B) |
| R-2 | 28 | B($\nearrow$) (Rise-up at the signal B) | A(H) ("H" level of the signal A) |
| R-3 | 26 | A($\searrow$) (Fall-down at the signal A) | B(H) ("H" level of the signal B) |
| R-4 | 30 | B($\searrow$) (Fall-down at the signal B) | A(L) ("L" level of the signal B) |
| Anticlockwise L-1 | 29 | B($\nearrow$) | A(L) |
| L-2 | 25 | A($\nearrow$) | B(H) |
| L-3 | 31 | B($\searrow$) | A(H) |
| L-4 | 27 | A($\searrow$) | B(L) |

As can be seen from the above table, there is no identical combination of modes between the encoder output signals A and B in the clockwise and anticlockwise rotations of the encoder shaft and the discrimination of the rotational directions can easily be made by positively utilizing the combinations. Therefore, the present invention utilizes the dour combinations of the modes obtained for one period of the signals A and B.

In the fundamental arrangement of the present invention shown in Fig. 6, numerals 20 and 22 represent rise-up detectors for detecting the rise-up edges of the pulses contained in the encoder output signals A and B, respectively; numerals 21 and 23 represent fall-down detectors for detecting the fall-down edges of the pulses contained in the encoder output signals A and B, respectively; numerals 24, 25, 26, 27, 28, 29, 30 and 31, each represents an AND gate; and numerals 32 and 33, each represents an OR gate.

As listed in the above table, the AND gates 24—31 issue output signals corresponding to the modes R-1—R-4 and L-1—L-4, respectively.

In accordance with these output signals of the AND gates 24—31, an output pulse, which corresponds to the clockwise rotation of the shaft, is issued from the output terminal R of the OR gate 32, and another output pulse, which corresponds to the anticlockwise rotation of the shaft, is issued from the output terminal L of the OR gate 33.

The rise-up edge detectors 20 and 22 and the fall-down edge detectors 21 and 23 perform a function as shown timing charts in Figs. 7(a), 7(b) and 7(c), wherein the encoder output signal A is exclusively taken as an example. Namely, when a signal A shown in Fig. 7(a) is fed to the input terminal 201, a positive pulse as shown in Fig. 7(b) is issued from the rise-up edge detector 20 while a positive pulse as shown in Fig. 7(c) is issued from the fall-down edge detector 21. By the way, it is to be noted that in the pulse detection circuit of the present invention, the above-mentioned operation is applicable irrespective of polarity of the pulse. That is, a negative pulse can equally be treated by simply reversing the logic of the circuit.

The performance of the circuit shown in Fig. 6 will be elucidated below by referring to the timing charts shown in Figs. 8(a)—8(h), wherein each of the timing charts indicated by (a), (b), (c), (d), (e), (f), (g) and (h) corresponds to each of the signals appeared at the points a, b, c, d, e, f, g and h of Fig. 6.

When the encoder output signals A and B, each of which contains chattering noises as indicated by the timing charts (a) and (b) in Fig. 8, are fed to the input terminals 201 and 202, respectively, the rise-up detectors 20 and 22 generate pulse signals in response to the rise-up edges of the pulse contained in the encoder output signal as indicated by the timing charts (c) and (e) in Fig. 8, while the fall-down detectors 21 and 23 generate pulse signals in response to the fall-down edges of the pulse contained in the encoder output signal as indicated by the timing charts (e) and (f) in Fig. 8. In the results, the pulse signals as indicated by the timing charts (g) and (h) in Fig. 8 are obtained from the output terminals R and L of the OR gates 32 and 33.

When it is set that the output terminal R being positive and the output terminal L being negative, the pulse $P_1$ is counted as +1 but is cancelled by −1 corresponding to the subsequent pulse $P_2$ to make the count value 0. Similarly, the count value becomes +1 by the pulse $P_3$ but turns to 0 again by the pulse $P_4$ and then becomes +1 by the pulse $P_5$.

As elucidated above, even if the encoder output signals A and B contain any numbers oc chattering noise, an erroneous counting due to the chattering noise can effectively be prevented.

Figs. 9 through 14 inclusive show concrete circuit arrangements of the rise-up/fall-down detectors which may be included in the pulse detection circuit embodying the present invention and, will be elucidated in detail below.

An embodiment shown in Fig. 9 comprises a delay circuit 34 having a delay time τ, an inverter 35, an AND gate 36 and a NOR gate 37. In Fig. 10, there are shown timing charts of the signals appeared at various part of the circuit shown in Fig. 9. The timing charts (a), (b), (c) and (d) of Fig. 10 correspond to the signals at a, b, c and d of Fig. 9.

Namely, when an encoder output signal as shown by the timing chart (a) is fed to the input terminal of the circuit, an inversed signal with a delay by τ as shown by the timing chart (b) is issued from the inverter 35, thereby a signal including a pulse of the duration τ as shown by the timing chart (c) is obtained from the AND gate 36 in response to the rise-up edge of the pulse contained in the encoder output signal (a), while a signal including a pulse of the duration τ as shown by the timing chart (d) is obtained from the NOR gate 37 in response to the fall-down edge. The delay circuit may be embodied simply by a resistor and a capacitor.

The shown (in solid lines) circuit might sometimes be unsatisfactory, because it could not respond to an input pulse of a width shorter than τ and may cause an erroneous operation due to the difference in threshold levels of each gates in response to an input pulse of a width which approximates to τ. In order to prevent such a drawback by cancelling input pulse shorter than τ, a delay circuit 34' of delay time larger than τ may additionally be provided in the preceding stage of the circuit as shown by broken line in Fig. 9.

Another embodiment shown in Fig. 11 comprises a two-stage shift register composed of two D-flip-flops 38 and 39, an AND gate 36, a NOR gate 37 and a clock oscillator 40. The output signals Q and $\bar{Q}$ are fed to the AND gate 36 and the NOR gate 37. The output signal $\bar{Q}$ derived from the D-flip-flop 39 is an inverted output signal Q from the D-flip-flop 38 with a delay as long as one period in the clock pulse of the clock oscillator 40. The signal processing by this circuit, other than specifically indicated above, is identical with that shown in Fig. 9.

In the embodiment shown in Fig. 11, if an input signal containing pulse the duration of which approximates to the period of the clock pulse is fed to the circuit, an erroneous counting may result therefrom because the output signal from the AND gate 36 is closely followed by that from the NOR gate 37 to make the fall-down edge of the former coincide with the rise-up edge of the latter as shown in Fig. 12. In Fig. 12, the timing chart (a) represents an input signal appeared at a in Fig. 11, that (b) represents an output signal of the AND gate 36 appeared at b in Fig. 11, that (c) represents an output signal of the NOR gate 37 appeared at c in Fig. 11, and that (d) represents a clock signal appeared at d in Fig. 12, respectively.

The above-mentioned erroneous counting can be prevented by providing an additional circuit for processing the outputs of the circuit shown in Fig.

11. The additional circuit may be embodied as Fig. 13, wherein a RS-flip-flop, comprising four NOR gates 41, 42, 43 and 44 and an inverter 45, is connected to the output terminals of the AND gate 36 and NOR gate 37 respectively and is designed to be reset at the fall-down edge of the clock pulse CP (from the clock oscillator shown in Fig. 11). In Fig. 14, a timing chart (a) represents an input signal appeared at a, the input terminal of the NOR gate 41, of Fig. 13, that (b) represents an input signal appeared at b, the input terminal of the NOR gate 43 of Fig. 13, that (c) represents a clock pulse CP, that (d) represents an output signal appeared at d, the output terminal of the NOR gate 42 of Fig. 13, and that (e) represents an output signal appeared at e, the output terminal of the NOR gate 44, respectively.

## Claims

1. A pulse detection circuit for detecting pulses occurring in the form of a pair of pulse trains A, B, which may be in either of two mutual phase relationships, comprising a pair of input terminals (201, 202), one for each pulse train, each of said input terminals connected to a respective combination (2021, 2223) of a rise-up edge detector and a fall-down edge detector generating rise-up edge output signals $A\uparrow$ or $B\uparrow$ and fall-down edge output signals $A\downarrow$ or $B\downarrow$ in response to the rise-up and fall-down edges respectively of said pulses and combinational logic means (24—33) receiving as inputs said pulse trains and the outputs of said edge detectors and operable to generate at first (R) and second (L) output terminals respectively a first output signal R representing a first logical function

$$R = A\downarrow \cdot B + A\uparrow \cdot \overline{B} + \overline{A} \cdot B\downarrow + A \cdot B\uparrow$$

indicative of the occurrence of one of said pulses with the pulse trains in a first of said two mutual phase relationships and a second output signal L representing a second logical function

$$L = A\downarrow \cdot \overline{B} + A\uparrow \cdot B + A \cdot B\downarrow + \overline{A} \cdot B\uparrow$$

indicative of the occurrence of one of said pulses with the pulse trains in a second of said two mutual phase relationships characterised in that each combination (2021, 2223) of rise-up edge detector and fall-down edge detector comprises a two-stage shift register (38, 39; Fig. 11) whose data input (D) is connected to a respective said input terminal (201, 202), a clock oscillator (40) which supplies a clock pulse to shift said shift register, and first (41, 42; Fig. 13) and second (43, 44; Fig. 13) RS flip-flop circuits whose set inputs are constituted by the AND-ed (b; Fig. 11) and NOR-ed (c; Fig. 11) outputs respectively of said shift register stages (38, 39) and whose reset inputs are derived from the clock pulse from said clock oscillator (40) and whose outputs (d, e; Fig. 13) constitute the said rise-up edge output signals

$A\uparrow$, $B\uparrow$ and fall-down edge outputs signals $A\downarrow$, $B\downarrow$ respectively.

2. A pulse detection circuit as claimed in Claim 1 characterised in that said combinational logic means comprises a first gating stage composed of first (24), second (25), third (26), fourth (27), fifth (28), sixth (29), seventh (30) and eighth (31) dual input AND-gates generating respectively the logical products $A\uparrow \cdot \overline{B}$, $A\uparrow \cdot B$, $A\downarrow \cdot B$, $A\downarrow \cdot \overline{B}$, $A \cdot B\uparrow$, $\overline{A} \cdot B\uparrow$, $\overline{A} \cdot B\downarrow$, $A \cdot B\downarrow$ and a second gating stage composed of first (32) and second (33) quad input OR-gates receiving as inputs the outputs of said AND-gates (24—31); the outputs of said first (24), third (26), fifth (28) and seventh (30) AND-gates forming the inputs to said first OR-gate (32), and the outputs of said second (25), fourth (27), sixth (29) and eighth (31) AND-gates forming the inputs to said second OR-gate (33), the outputs of said first and second OR-gates (32, 33) constituting the logical functions R and L respectively.

## Patentansprüche

1. Impulserkennungsschaltung zur Erkennung von Impulsen, die in Form eines Paares von Impulszügen A, B auftreten, die in jeweils einer von zwei wechselseitigen Phasenbeziehungen stehen können, umfassend: ein Paar Eingangsanschlüsse (201, 202), von denen eine für je einen Impulszug vorgesehen ist, wobei jeder der Eingangsanschlüsse an eine entsprechende Kombination (2021, 2223) jeweils eines Anstiegsflanken-detektors und eines Abfallsflanken-Detektors angeschlossen ist, die Anstiegsflankenausgangssignale $A\uparrow$ oder $B\uparrow$ und Abfallsflankenausgangssignale $A\downarrow$ oder $B\downarrow$ als Antwort auf die Anstiegs- beziehungsweise Abfallsflanken der Impulse erzeugen, und Schaltnetze (24—33), die die Impulszüge und die Ausgangssignale der Flankendetektoren als Eingangssignale erhalten und so verarbeiten, daß an dem ersten (R) beziehungsweise dem zweiten (L) Ausgangsanschluß ein erstes Ausgangssignal R erzeugt wird, das eine erste logische Funktion

$$R = A\downarrow \cdot B + A\uparrow \cdot \overline{B} + \overline{A} \cdot B\downarrow + A \cdot B\uparrow$$

darstellt und das Auftreten eines der Impulse anzeigt, wenn die Impulszüge sich in einer ersten der beiden wechselseitigen Phasenbeziehungen befinden, und ein zweites Ausgangssignal L erzeugt wird, das eine zweite logische Funktion

$$R = A\downarrow \cdot \overline{B} + A\uparrow \cdot B + A \cdot B\downarrow + \overline{A} \cdot B\uparrow$$

darstellt und das Auftreten eines der Impulse anzeigt, wenn die Impulszüge sich in einer zweiten der beiden wechselseitigen Phasenbeziehungen befinden, dadurch gekennzeichnet, daß jede Kombination (2021, 2223) von Anstiegsflanken-Detektor und Abfallsflanken-Detektor jeweils ein zweistufiges Schieberegister (38; 39; Fig. 11), dessen Dateneingang (D) mit einem entsprechenden Eingangsanschluß (201, 202) verbunden ist, einen Taktoszillator (40), der einen Taktimpuls zum Weiterschalten des Schieberegisters abgibt, sowie erste (41, 42; Fig. 13) und zweite (43, 44; Fig. 13) RS-Flip-Flop-Schaltungen aufweist, deren Setz-Eingänge durch die UNDverknüpften (b; Fig. 11) bzw. NOR-verknüpften (c; Fig. 11) Ausgangssignale der Schieberegisterstufen (38, 39) gebildet werden und deren Rücksetz-Eingänge von dem Taktimpuls des Taktoszillators (40) abgeleitet werden und dessen Ausgangssignale (d, e; Fig. 13) die Anstiegsflankenausgangssignale $A\uparrow$, $B\uparrow$ beziehungsweise Abfallsflankenausgangssignale $A\downarrow$, $B\downarrow$ bilden.

2. Impulserkennungsschaltung nach Anspruch 1, dadurch gekennzeichnet, daß das Schaltnetz eine erste Verknüpfungsgliederstufe, die aus ersten (24), zweiten (25), dritten (26), vierten (27), fünften (28), sechsten (29), siebten (30) und achten (31) Zweiereingangs-UND-Gliedern bestehen, die jeweils die logischen Produkte $A\uparrow.\bar{B}$, $A\uparrow.B$, $A\downarrow.B$, $A\downarrow.\bar{B}$, $A.B\uparrow$, $\bar{A}.B\uparrow$, $\bar{A}.B\downarrow$, $A.B\downarrow$ erzeugen, und eine zweite Verknüpfungsgliederstufe umfaßt, die aus ersten (32) und zweiten (33) Vierereingangs-ODER-Gliedern besteht, die als Eingangssignale die Ausgangssignale der UND-Glieder (24—31) erhalten, wobei die Ausgangssignale der ersten (24), dritten (26), fünften (28) und siebten (30) UND-Glieder die Eingangssignale für die ersten ODER-Glieder (32) bilden, und die Ausgangssignale der zweiten (25), vierten (27), sechsten (29) und achten (31) UND-Glieder die Eingangssignale für die zweiten ODER-Glieder (33) bilden, und die Ausgangssignale der ersten und zweiten ODER-Glieder (32, 33) die logischen Funktionen R beziehungsweise L bilden.

**Revendications**

1. Circuit de détection d'impulsions pour la détection d'impulsions se produisant sous la forme d'une paire de trans d'impulsions A, B, qui peuvent présenter l'une ou l'autre de deux relations de phase mutuelles, comprenant une paire de bornes d'entrée (201, 202), à raison d'une pour chaque train d'impulsions, chacune de ces bornes d'entrée étant connectée à une combinaison respective (2021, 2223) d'un détecteur de front montant et d'un détecteur de front descendant générant des signaux de sortie de front montant $A\uparrow$ ou $B\uparrow$ et des signaux de sortie de front descendant $A\downarrow$ ou $B\downarrow$, respectivement, en réponse aux fronts montant et descendant desdites impulsions et des moyens de logique combinataires (24—33) recevant en tant qu'entrées lesdits trains d'impulsions et les sorties desdits détecteurs de front et pouvant fonctionner en produisant respectivement sur une première (R) et une seconde (L) borne de sortie un premier signal de sortie R représentant une première fonction logique

$$R=A\downarrow.B+A\uparrow.\bar{B}+\bar{A}.B\downarrow+A.B\uparrow$$

indiquant l'apparition de l'une desdites impulsions dans les trains d'impulsions se trouvant dans une première desdites deux relations de phase mutuelle, et un second signal de sortie L représentant une seconde fonction logique

$$\bar{L}=A\downarrow.\bar{B}+A\uparrow.B+A.B\downarrow+\bar{A}.B\uparrow$$

indiquant l'apparition de l'une desdites impulsions dans les trains d'impulsions se trouvant dans la seconde desdites deux relations de phase mutuelle caractérisé en ce que: chaque combinaison (2021, 2223) du détecteur de front montant et du détecteur de front descendant comprend un registre à décalage à deux étages (38, 39; figure 11) dont l'entrée de donnée (D) est connectée à une borne respective desdites bornes d'entrée (201, 202), un oscillateur d'horloge (40) qui fournit une impulsion d'horloge pour décaler ledit registre à décalage, et un premier (41, 42; figure 13) et une second (43, 44; figure 13) circuit à bascule RS dont les entrées de positionnement sont respectivement constituées par les sorties soumises à un ET (b; figure 11) et à un NON-OU (c; figure 11) desdits étages du registre à décalage (38, 39) et dont les entrées de réinitialisation sont obtenues à partir de l'impulsion d'horloge provenant dudit oscillateur d'horloge (40) et dont les sorties (d, e; figure 13) constituent respectivement lesdits signaux de front montant de sortie $A\uparrow$, $B\uparrow$ et lesdits signaux de front descendant de sortie $A\downarrow$, $B\downarrow$.

2. Circuit de détection d'impulsions selon la revendication 1, caractérisé en ce que lesdits moyens de logique combinatoir comprennent un premier étage monté en porte composé d'une première (24), d'une seconde (25), d'une troisième (26), d'une quatrième (27), d'une cinquième (28), d'une sixième (29), d'une septième (30) et d'une huitième (31) porte ET d'entrée double produisant respectivement les produits logiques $A\uparrow.\bar{B}$, $A\uparrow.B$, $A\downarrow.B$, $A\downarrow.\bar{B}$, $A.B\uparrow$, $\bar{A}.B\uparrow$, $\bar{A}.B\downarrow$, $A.B\downarrow$ et un second étage monté en porte composé d'une première (32) et d'une seconde (33) porte OU quadruple d'entrée recevant en tant qu'entrées les sorties desdites portes ET (24—31); les sorties desdites première (24), troisième (26), cinquième (28) et septième (30) portes ET formant les entrées de ladite première porte OU (32), et les sorties desdites seconde (25), quatrième (27), sixième (29) et huitième (31) portes ET formant les entrées de ladite seconde porte OU (33), les sorties desdites première et seconde portes OU (32, 33) constituant respectivement les fonctions logiques R et L.

# F I G.1

A ⊔⊔⊔⊔
B ⊓⊓⊓⊓

# F I G.2

Encoder output
signal A

T

→ Time

Encoder output
signal B

→ Time

→ Clockwise rotation

Anticlockwise rotation ←

# F I G.3 (Prior Art)

$2^1$ $2^2$ $2^3$ $2^n$

Up-down
counter

6

Encoder output
signal A

CP

UP/DOWN

Encoder output
signal B

1

F I G. 4 (Prior Art)

```
                                    ┌──10
A ○──┬──────────────┐
     │    ╲╲        │
     ⌇     ╲ )──────┤ )────┐
     │    ╱╱  ╲      │       │
     ─┬─        9    │       │
      ⏚                       │
                              │──11    7
              ○───────────────┤ )──○  ⊓⊓  Anticlockwise
                         ┌────┤ )          output
                         │    │
                         │           8
                         │    ┌──12
              ▷○─────────┼────┤ )──○  ⊓⊓  Clockwise
               13        │    │          output
                         └────┘
```

F I G. 5 (Prior Art)

FIG.6

FIG.7

F I G. 8

F I G.9

F I G.10

FIG. 11

FIG. 12

(a)

Time ➞

(b)

Time ➞

(c)

Time ➞

(d)

Time ➞

F I G. 13

F I G. 14

(a)    Time ⟶

(b)    Time ⟶

(c)    Time ⟶

(d)    Time ⟶

(e)    Time ⟶

7